# EUROPÄISCHE PATENTSCHRIFT

(11) **EP 2 057 720 B1**
(45) Veröffentlichungstag und Bekanntmachung des Hinweises auf die Patenterteilung: **14.09.2011**
(21) Anmeldenummer: 07802923.8
(22) Anmeldetag: 27.08.2007
(51) Int. Cl.: H01S 1/02

(54) **VORRICHTUNG UND VERFAHREN ZUR ERZEUGUNG VON TERAHERTZ-STRAHLUNG**
DEVICE AND METHOD FOR THE GENERATION OF TERAHERTZ RADIATION
DISPOSITIF ET PROCÉDÉ POUR LA PRODUCTION DE RAYONNEMENT DE L'ORDRE DU TÉRAHERZ

(30) Priorität: 01.09.2006 DE 102006041728
(43) Veröffentlichungstag der Anmeldung: 13.05.2009
(73) Patentinhaber: Forschungsverbund Berlin E.V., 12489 Berlin (DE)
(72) Erfinder: TRÄNKLE, Günther, 12557 Berlin (DE); ERBERT, Götz, 12557 Berlin (DE); KLEHR, Andreas, 13156 Berlin (DE); HOFMANN, Martin, 44797 Bochum (DE)
(74) Vertreter: Gulde Hengelhaupt Ziebig & Schneider
(86) Internationale Anmeldenummer: PCT/EP2007/058885
(87) Internationale Veröffentlichungsnummer: WO 2008/025746

(56) Entgegenhaltungen:
- US-A1- 2005 242 287
- US-B1- 6 388 799
- HOFFMANN S ET AL: "Four-wave mixing and direct terahertz emission with two-color semiconductor lasers" APPLIED PHYSICS LETTERS, AIP, AMERICAN INSTITUTE OF PHYSICS, MELVILLE, NY, US, Bd. 84, Nr. 18, 3. Mai 2004 (2004-05-03), Seiten 3585-3587, XP012061317 ISSN: 0003-6951 in der Anmeldung erwähnt
- HOFFMANN S ET AL: "Two-colour diode lasers for generation of THz radiation; Two-colour diode lasers for generation of THz radiation" SEMICONDUCTOR SCIENCE AND TECHNOLOGY, IOP, BRISTOL, GB, Bd. 20, Nr. 7, 1. Juli 2005 (2005-07-01), Seiten S205-S210, XP020086541 ISSN: 0268-1242
- BRENNER C, TUYEN N, HOFFMANN S, HOFMANN M: "Room temperature Terahertz generation with semiconductor lasers" PROC OF SPIE, Bd. 6194, 19. April 2006 (2006-04-19), Seiten 61940H-1-61940H-8, XP002460675
- MATUS M ET AL: "Dynamics of two-color laser systems with spectrally filtered feedback" JOURNAL OF THE OPTICAL SOCIETY OF AMERICA B (OPTICAL PHYSICS) OPT. SOC. AMERICA USA, Bd. 21, Nr. 10, Oktober 2004 (2004-10), Seiten 1758-1771, XP002460676 ISSN: 0740-3224
- KOHEN S ET AL: "Electromagnetic modeling of terahertz quantum cascade laser waveguides and resonators" JOURNAL OF APPLIED PHYSICS AIP USA, Bd. 97, Nr. 5, 1. März 2005 (2005-03-01), Seiten 53106-1, XP002460677 ISSN: 0021-8979
- WEI SHI ET AL: "Designs of terahertz waveguides for efficient parametric terahertz generation" APPLIED PHYSICS LETTERS AIP USA, Bd. 82, Nr. 25, 23. Juni 2003 (2003-06-23), Seiten 4435-4437, XP002460678 ISSN: 0003-6951

## Beschreibung

Die Erfindung betrifft eine Vorrichtung zur Erzeugung von elektromagnetischer Strahlung im Infrarotbereich mit den in Anspruch 1 genannten Merkmalen, insbesondere betrifft die Erfindung eine Strahlungsquelle für einen Frequenzbereich zwischen 0.1 THz und etwa 10 THz (Terahertz) basierend auf einer Halbleiterlaserstruktur.

Es ist grundsätzlich bekannt, dass kohärente Strahlung bei bestimmten Frequenzen im fernen Infrarotbereich zum Beispiel durch Moleküllaser, die mit CO₂-Lasern gepumpt werden, erzeugt werden kann. Im Wellenlängenbereich von 3 mm bis 30 µm (von 100 GHz bis 10 THz) liegen viele der für die Spektroskopie von Molekülen und Festkörpern interessierenden Frequenzen und Wellenlängen. Der Einsatz einer auf einem Halbleiterchip eines Wafers realisierten Strahlungsquelle für diesen Bereich der THz-Strahlung mit ausreichender Ausgangsleistung im Bereich zwischen 1 µW und 1 W ist von hoher technischer Bedeutung für spektroskopische Anwendungen in allen Fragen des Umweltschutzes, der Analytik und Materialcharakterisierung in Medizin und Biologie sowie der Chemie und Physik.

Weitere Anwendungsgebiete vorgenannter Strahlungsquellen sind die biomedizinische Bildgebung, die Metrologie sowie die Kommunikationstechnik und die Sicherheitstechnik.

Zur Generierung breitbandiger THz-Strahlung ist es beispielsweise aus P.R. Smith, D.H. Auston, and M.C. Nuss, IEEE J. Quantum Electron. 24, 255 (1998); A. Leitenstorfer, S. Hunsche, J. Shah, M.C. Nuss, and W.H. Knox, Phys. Rev. B61, 16642 (2000) und S. Hunsche, M. Koch I. Brener, and M.C. Nuss, Optics Commun. 150, 22 (1998) bekannt, Kurzpuls-Titan-Saphir Laser in Verbindung mit optischer Gleichrichtung in nichtlinearen Kristallen, photoleitenden Antennen oder PIN-Dioden zu verwenden. Aufgrund ihrer enormen Komplexität werden diese Verfahren zurzeit nur in Forschungslaboratorien genutzt; eine Massenanwendung kommt daher nicht in Betracht.

Weiterhin ist es aus R. Köhler, A. Tredicucci, F. Beltram, H. E. Beere, E.H. Linfield, A.G. Davies, and D.A. Richie, Opt. Lett. 28, 810 (2003) und C. Sirtori, C. Gmachl, F. Capasso, J. Faist, D.L. Sivco, A.L. Hutchinson, and A.Y. Cho, Opt. Lett. 23, 366 (1998) bekannt, Quanten-Kaskadenlaser zu verwenden, bei denen eine spezielle WellenleiterGeometrie, z.B. unter Einbeziehung von Oberflächen-Plasmonen benutzt wird. Darüber hinaus ist zur Erzeugung von THz-Strahlung die Verwendung von Germanium Lasern aus E. Bründermann, D.R. Chamberlin, and E.E. Haller, Appl. Phys. Lett. 76, 2991 (2000) bekannt. Diese Applikationen sind zwar kompakter als die breitbandigen THz-Strahlungsquellen mit Kurzpulslasern, jedoch ist zur Generation entsprechender THz-Leistungen (im mW-Bereich) eine kryogene Kühlung erforderlich.

Weiterhin ist die Erzeugung von THz-Strahlung mittels Differenzfrequenzerzeugung mit zwei kontinuierlichen Laserquellen mit passendem Frequenzabstand mittels Photomischern aus K.J. Siebert, H. Quast, R. Leonhardt, T. Löffler, M. Thomson, T. Bauer, H. Roskos, and S. Czasch, Appl. Phys. Lett. 80, 3003 (2002) und A. Nahata, J.T. Yardley, and T.F. Heinz, Appl. Phys. Lett. 81, 963 (2002); S. Verghese, K.A. McIntiosh, S. Calawa, W.F. Dinatale, E.K. Duerr, and K.A. Molvar, Appl. Phys. Lett. 73, 3824 (1998) bekannt. Als Ausgangs-Lichtquellen hierfür können Faserlaser, kontinuierliche Festkörperlaser oder auch Diodenlaser eingesetzt werden. Nachteilhafterweise ist der Aufwand für solche Anordnungen relativ hoch aufgrund des Erfordernisses der Stabilisierung der beiden Laser zueinander.

Weiterhin ist die Erzeugung von THz-Strahlung mittels Differenzfrequenzerzeugung bei Zweifarben-Diodenlasern aus M. Tani, P. Gu, M. Hyodo, K. Sakai, T. Hidaka, Optical and Quantum Electron. 32, 503 (2000) und C.-L. Wang and C.-L. Pan, Opt. Lett. 20, 1292 (1995); P. Gu, F. Chang, M. Tani, K. Sakai, and C.-L. Pan, Jap. J. Appl. Phys. 38, L1246 (1999) bekannt. Diese Systeme verwenden Resonatoren, die eine Rückkopplung auf zwei Wellenlängen liefern. Diese Resonatoren können entweder durch zwei monolithisch integrierte Bragg-Gitter oder auch durch spezielle externe Resonatoren realisiert werden. Die Konzepte zur THz-Erzeugung über Photomischung mit zwei separaten Lasern oder mit Zweifarbenlasern liefern jedoch im Vergleich zu Quantenkaskadenlasern und zum p-Germanium-Laser deutlich niedrigere Ausgangsleistungen und sind - abgesehen von der nicht erforderlichen kryogenen Kühlung - prinzipiell komplexer aufgebaut.

Aus A.A. Belyanin et al., Nanotechnology 12, 450 (2001)ist bekannt, dass parametrische Verstärkung von THz-Strahlung in Halbleiterstrukturen möglich ist, die elektronische Übergänge (z.B. Intersubbandübergänge in Quantenfilmen) in Resonanz mit der THz-Strahlung aufweisen.

Weiterhin ist aus S. Hoffmann, M. Hofmann, E. Bründermann, M. Havenith, M. Matus, J.V. Moloney, A.S. Moskalenko, M. Kira, S.W. Koch, S. Saito and K. Sakai, Appl. Phys. Lett. 84, 3585 (2004)bekannt, dass die Erzeugung von THz-Strahlung bei Zweifarben-Diodenlasern auch mittels Differenzfrequenzerzeugung in der Laserdiode selbst erfolgen kann, allerdings aufgrund der starken Absorption des dotierten Substrats herkömmlicher Laserdioden nur mit ganz geringen Leistungen im Bereich unter einem nW.

Es ist daher Aufgabe der vorliegenden Erfindung, eine Strahlungsquelle für den THz-Bereich anzugeben, die ausreichende hohe Leistungen trotz eines kompakten und preiswert herzustellenden Aufbaus liefert. Weiterhin soll die erfindungsgemäße (vorzugsweise kohärente) Strahlungsquelle keine Kühlung benötigen.

Diese Aufgaben werden erfindungsgemäß durch die Merkmale des Patentanspruchs 1 gelöst. Bevorzugte Ausgestaltungen der Erfindung sind in den Unteransprüchen enthalten.

Eine Dämpfung von kleiner als 90% entlang der Längsachse der Wellenleiterschicht bei einem Durchgang bedeutet, dass die Intensität der THz-Strahlung nach einem Durchgang durch das Substrat (entlang der Längsachse) über die Länge von erstem und zweitem Bereich mindestens 10% der ursprünglichen Intensität besitzt. Mit anderen Worten ist das Substrat im ersten und zweiten Bereich aus einem solchen Material ausgebildet, dass es THz-Strahlung bei einem Durchgang über die Substratlänge (erster und zweiter Bereich) lediglich bis zu 90% (bzw. einem Absorptionskoeffizient α<=11.5cm⁻¹ bei einer bevorzugten Resonatorlänge von 5 mm oder kleiner, besonders bevorzugt 2 mm oder kleiner),vorzugsweise 70% (bzw. α<=6.0cm⁻¹ bei einer bevorzugten Resonatorlänge von 5 mm oder kleiner, besonders bevorzugt 2 mm oder kleiner), noch bevorzugter 40% (α<=2.6cm⁻¹ bei einer bevorzugten Resonatorlänge von 5 mm oder kleiner, besonders bevorzugt 2 mm oder kleiner) dämpft, also höchstens auf 10% (vorzugsweise 30%, noch bevorzugter 60%) abschwächt. Dies gilt analog für das dritte Material (zusätzliche Resonatorschicht).

Vorzugsweise besteht das zweite Substratmaterial und/oder das dritte Material aus dem Dielektrikum, besonders bevorzugt aus einem organischen Dielektrikum, noch bevorzugter aus Benzocyclobenzen (BCB).

Der erste und zweite Bereich des Substrats ist vorzugsweise als ein durchgehendes Substrat ausgebildet, wobei erster und zweiter Bereich aus unterschiedlichen Materialien ausgebildet sein können (vorzugsweise erster Bereich aus einem halbleitenden Material zur Injektion von Ladungsträgern und zweiter Bereich aus einem organischen Dielektrikum). Vorzugsweise fungiert das Substrat (in seiner Gesamtheit, also sich über ersten und zweiten Bereich erstreckend) als Trägersubstrat für die aktive Schicht, die Wellenleiterschichten und die Mantelschichten. Vorzugsweise weist das Substrat eine (vorzugsweise kontinuierliche) Dicke zwischen 80 µm und 160 µm auf.

Die Schicht des aktiven Mediums, die erste und zweite Wellenleiterschicht, die erste und zweite Mantelschicht erstrecken sich vollständig über den ersten und zweiten Bereich des Substrats. Die Kontakte erstrecken sich vorzugsweise nur über den ersten Bereich, die Schicht aus dem dritten Material (zusätzliche Resonatorschicht) sowie die reflektierenden Schichten nur über den zweiten Bereich.

Vorzugsweise kontaktiert die Schicht des aktiven Mediums direkt die erste und zweite Wellenleiterschicht; die erste Wellenleiterschicht kontaktiert vorzugsweise direkt die erste Mantelschicht; die zweite Wellenleiterschicht kontaktiert vorzugsweise direkt die zweite Mantelschicht; die erste Mantelschicht kontaktiert vorzugsweise direkt das Substrat sowohl im ersten als auch im zweiten Bereich.

Vorzugsweise kontaktiert die zweite Mantelschicht im ersten Bereich direkt einen elektrischen Kontakt oder eine damit verbundene Kontaktschicht. Vorzugsweise kontaktiert die zweite Mantelschicht im zweiten Bereich direkt die (zusätzliche Resonator-) Schicht aus dem dritten Material.

Mit anderen Worten sind im ersten Bereich neben Substrat, der Schicht des aktiven Mediums, den Wellenleiterschichten und den Mantelschichten lediglich elektrische Kontakte sowie ggf. Kontaktschichten vorgesehen, wobei im zweiten Bereich neben Substrat, der Schicht des aktiven Mediums, den Wellenleiterschichten und den Mantelschichten keine elektrischen Kontakte (sowie ggf. Kontaktschichten), sondern anstelle dieser das Substrat bzw. eine (zusätzliche Resonator-) Schicht aus dem dritten Material in Oppositionsstellung zum Substrat vorgesehen sind, wobei Substrat und zusätzliche Resonatorschicht auf ihren äußeren Flächen jeweils eine für THz-Strahlung reflektierende Schicht zur Ausbildung eines Resonators aufweisen. Die Idee ist also, ein Substrat mit geringer Dämpfung für THz-Strahlung vorzusehen, welches aufgrund der geringen Dämpfung im zweiten Bereich (zusammen mit zusätzlicher Resonatorschicht und den reflektierenden Schichten) auch Teil des Resonators für die Terahertzstrahlung sein kann. Dabei besteht die Funktion der zusätzlichen Resonatorschicht darin, neben der geringen Dämpfung für THz-Strahlung eine geeignete Dimensionierung für den Resonator zu ermöglichen, um eine möglichst hohe Intensität der THz-Strahlung und damit eine hohe Effizienz zu realisieren.

Die Erzeugung der optischen Welle wird daher lediglich im ersten Bereich (in dem elektrische Kontakte vorhanden sind) realisiert. Die aufgrund der Differenzfrequenzerzeugung erzeugte THz-Strahlung kann im zweiten Bereich mittels des Resonators derart geführt und verstärkt werden, dass ausreichend hohe Leistungen trotz eines kompakten und preiswert herzustellenden Aufbaus erreicht werden können.

Vorzugsweise bestehen Substrat und/oder zusätzliche Resonatorschicht aus einem Material mit einer Absorption für elektromagnetische Strahlung in Bereich von 0.1 THz bis 10 THz von weniger als 11.5cm⁻¹ (entspricht ca. 90% Dämpfung bei bevorzugten Dimensionen), 6.0 cm⁻¹ (entspricht ca. 70% Dämpfung bei bevorzugten Dimensionen) oder 2.6cm⁻¹ (entspricht ca. 40% Dämpfung bei bevorzugten Dimensionen).

Durch die Ausbildung einer Struktur, die sowohl eine Wellenleiterschicht für eine optische Welle als auch eine Wellenleiterschicht für eine elektromagnetische Welle in Bereich von 0.1 THz bis 10 THz aufweist, kann eine Strahlungsquelle für Terahertz-Strahlung, die auf dem Prinzip der Differenzfrequenzerzeugung basiert, besonders kompakt ausgebildet werden. Dazu ist es erfindungsgemäß vorgesehen, dass das verwendete Substrat in einem ersten Bereich, in dem die optische Welle erzeugt und geführt wird, aus einem semiisolierenden Material mit einer geringen Dämpfung für elektromagnetische Strahlung im Bereich von 0.1 THz bis 10 THz ausgebildet ist.

Weiterhin ist es vorgesehen, dass das Substrat (ebenfalls mit einer geringen Dämpfung für elektromagnetische Strahlung im Bereich von 0.1 THz bis 10 THz) in einem zweiten Bereich als Wellenleiter für die Terahertz-Strahlung fungiert, wobei durch Anordnung eines dritten Materials (ebenfalls mit einer geringen Dämpfung für elektromagnetische Strahlung im Bereich von 0.1 THz bis 10 THz) auf der vom Substrat abgewandeten Seite der Wellenleiterschichten für die optische Welle und entsprechender, reflektierender Schichten ein Verstärker bzw. Resonator für die Terahertz-Strahlung ausgebildet wird.

Erfindungsgemäß wird die Terahertz-Strahlung durch Differenzfrequenzerzeugung von zwei longitudinalen Moden im ersten Bereich generiert und im zweiten Bereich weiter geführt und verstärkt und schließlich ausgekoppelt. Die zwei longitudinalen Moden können zur Differenzfrequenzerzeugung sowohl intern in der Laserstruktur (beispielsweise durch frequenzselektive Elemente wie Gitter) als auch durch externe Rückkopplung angeregt und verstärkt werden. Vorzugsweise weist die Vorrichtung zwei (interne oder externe) frequenzselektive Elemente (vorzugsweise Gitter) auf, die zur Anregung von zwei unterschiedlichen Moden mit einem Wellenlängenabstand von 0,00001 nm bis 100 nm (bevorzugt von 0.5 nm - 30 nm, besonders bevorzugt von 1 nm - 10 nm) geeignet sind.

Um eine effiziente parametrische Verstärkung der erzeugten elektromagnetische Strahlung im Bereich von 0.1 THz bis 10 THz zu erzielen, kann die aktive Schicht vorzugsweise aus einem Material (z.B. Halbleiter-Quantenfilme, - Quantendrähte oder -Quantenpunkte) bestehen, das sich dadurch auszeichnet, dass es in ihm elektronische Übergänge zwischen quantisierten Niveaus gibt, die mit der zu erzeugenden Differenzfrequenz resonant sind.

Die Wellenleitergeometrie im zweiten Bereich wird so ausgelegt, dass sie eine Phasenanpassung zwischen den longitudinalen Moden und der elektromagnetischen Strahlung im Bereich von 0.1 THz bis 10 THz gewährleistet, d.h., dass erstere und letztere mit der gleichen Ausbreitungsgeschwindigkeit durch den zweiten Bereich propagieren. Dazu wird die optische Dicke des Wellenleiters durch Anpassung von Geometrie/Brechungsindex eingestellt.

Vorzugsweise weist das erste Substratmaterial Galliumarsenid, Indiumphosphid und/oder Galliumnitrid auf. Vorzugsweise ist die Dämpfung des ersten Substratmaterials für elektromagnetische Strahlung im Bereich von 0.1 THz bis 10 THz geringer als 90%, besonders bevorzugt geringer als 70 %. Vorzugsweise ist die Dämpfung des zweiten Substratmaterials (Substratmaterial im zweiten Bereich) sowie des dritten Materials (der zusätzlichen Resonatorschicht) für elektromagnetische Strahlung im Bereich von 0.1 THz bis 10 THz geringer als 40%, besonders bevorzugt geringer als 10%.

Vorzugsweise ist das dritte Material (das auf der dem Substrat abgewandten Seite des Wellenleiters angeordnet ist) lediglich im zweiten Bereich, jedoch nicht im ersten Bereich vorhanden. Ebenso ist vorzugsweise die reflektierende Schicht (die auf der der zweiten Mantelschicht abgewandten Seite der Schicht aus dem dritten Material und auf der der ersten Mantelschicht abgewandten Seite des zweiten Substratmaterials angeordnet ist) lediglich im zweiten Bereich, jedoch nicht im ersten Bereich vorhanden. Substratmaterial im zweiten Bereich und das dritte Material (zusätzliche Resonatorschicht) sind vorzugsweise identisch.

Vorzugsweise ist/sind das Substrat, mindestens eine Mantelschicht, mindestens eine Wellenleiterschicht und/oder die Schicht des aktiven Mediums (aktives Medium) planar ausgebildet. Vorzugsweise ist/sind das Substrat, mindestens eine Mantelschicht, mindestens eine Wellenleiterschicht und/oder die Schicht des aktiven Mediums (aktives Medium) streifenförmig ausgebildet. Vorzugsweise wird/werden das Substrat, mindestens eine Mantelschicht, mindestens eine Wellenleiterschicht und/oder die Schicht des aktiven Mediums (aktives Medium) kontinuierlich über den ersten Bereich und über den zweiten Bereich aufgebracht.

Vorzugsweise weist die reflektierende Schicht eine Reflektivität von größer 60%, besonders bevorzugt größer 80% für elektromagnetische Strahlung im Bereich von 0.1 THz bis 10 THz auf. Vorzugsweise ist die reflektierende Schicht aus Gold oder aus Aluminium ausgebildet.

Vorzugsweise ist der erste Kontakt auf der Unterseite des Substrats im ersten Bereich und der zweite Kontakt auf der zweiten Mantelschicht im ersten Bereich angeordnet. Vorzugsweise ist zwischen zweiter Mantelschicht und zweitem Kontakt eine Kontaktschicht angeordnet.

Vorzugsweise ist die erste Mantelschicht eine n-Mantelschicht, die erste Wellenleiterschicht eine n-Wellenleiterschicht, die zweite Mantelschicht eine p-Mantelschicht und die zweite Wellenleiterschicht eine p-Wellenleiterschicht. Vorzugsweise ist der erste Kontakt ein n-Kontakt, der zweite Kontakt ein p-Kontakt und die Kontaktschicht eine p-Kontaktschicht. Alternativ ist es vorgesehen, dass die erste Mantelschicht eine p-Mantelschicht, die erste Wellenleiterschicht eine p-Wellenleiterschicht, die zweite Mantelschicht eine n-Mantelschicht und die zweite Wellenleiterschicht eine n-Wellenleiterschicht ist, wobei der erste Kontakt ein p-Kontakt, der zweite Kontakt ein n-Kontakt und die Kontaktschicht eine n-Kontaktschicht ist. (n- steht für n-leitend und p- steht für p-leitend).

Vorzugsweise weist der erste Bereich des Substrats eine Ausdehnung entlang der Längsachse zwischen 200 µm und 1000 µm und der zweite Bereich des Substrats eine Ausdehnung entlang der Längsachse zwischen 1000 µm und 3000 µm auf.

Vorzugsweise entspricht die Schichtdicke des ersten Substratmaterials der Schichtdicke des zweiten Substratmaterials. Vorzugsweise entspricht die Schichtdicke des zweiten Substratmaterials der Schichtdicke des dritten Materials. Vorzugsweise beträgt die Dicke des ersten Substratmaterials, des zweiten Substratmaterials und des dritten Materials zwischen 80 und 160 µm (besonders bevorzugt 120µm).

Vorzugsweise weisen das vom zweiten Bereich abgewandte Ende des ersten Bereiches des Substrats eine senkrecht zur Längsachse angeordnete Frontfacette und das vom ersten Bereich abgewandte Ende des zweiten Bereiches des Substrats eine senkrecht zur Längsachse angeordnete Rückfacette auf. Vorzugsweise weisen die Frontfacette eine Reflektivität kleiner als 1%, besonders bevorzugt kleiner als 0.1% und die Rückfacette eine Reflektivität größer als 95%, besonders bevorzugt größer als 99% für elektromagnetische Strahlung im Bereich von 0.1 THz bis 10 THz auf.

Die erfindungsgemäße Vorrichtung ist vorzugsweise als kohärente Strahlungsquelle ausgebildet. Ferner weist die erfindungsgemäße Vorrichtung vorzugsweise keine Kühlung auf bzw. ist die erfindungsgemäße Vorrichtung vorzugsweise nicht mit einer Kühlung wirkverbunden.

Vorzugsweise ist der Wellenleiter im zweiten Teilbereich derart gestaltet, dass elektromagnetische Strahlung im Bereich von 0.1 THz bis 10 THz und optische Strahlung dieselbe oder eine im Wesentlichen gleiche Ausbreitungsgeschwindigkeit (Abweichung kleiner 3%) entlang der Längsachse der Wellenleiterschichten aufweisen. Dadurch kann erfindungsgemäß eine Phasenanpassung von (im ersten Bereich erzeugter) optischer Strahlung und (im zweiten Bereich geführter und verstärkter) THz-Strahlung erreicht werden, was zu einer erhöhten THz-Strahlungseffizienz führt.

Vorzugsweise weist das aktive Medium elektronische Übergänge auf, die mit der zu erzeugenden THz-Welle in Resonanz sind. Vorzugsweise weist die Vorrichtung zwei frequenzselektive Elemente auf, die zur Anregung von zwei unterschiedlichen Moden mit einem Wellenlängenabstand von 0,00001 nm bis 100 nm geeignet sind. Vorzugsweise besteht das frequenzselektive Element aus einem internen oder externen Gitter und/oder einem Prisma. Vorzugsweise ist an den ersten axialen Bereich zusätzlich ein (weiterer) Laser angekoppelt, wobei die von der aktiven Schicht angeregte Strahlung und die vom angekoppelten Laser generierte Strahlung einen Wellenlängenabstand von 0,00001 nm bis 100 nm aufweisen. Vorzugsweise ist zwischen dem ersten axialen Bereich und dem zweiten axialen Bereich ein Verstärker angeordnet. Das Substrat besteht vorzugsweise aus einem anorganischen halbleitenden Material.

Ein Verfahren zur Erzeugung von Strahlung weist folgende Verfahrensschritte auf:
- Erzeugung von longitudinalen Lasermoden einer Wellenlänge zwischen 300 nm und 2000 nm in einem ersten Teilbereich eines Wellenleiters durch Injektion von Ladungsträgern in eine in den Wellenleiter integrierte Schicht aus einem aktiven Material,
- Erzeugung von elektromagnetischer Strahlung durch Differenzfrequenzerzeugung von mindestens zwei longitudinalen Lasermoden im ersten Teilbereich des Wellenleiters mittels interner oder externer Rückkopplung, und
- verlustarme Führung und Verstärkung der durch die Differenzfrequenzerzeugung erzeugten Strahlung mittels eines einen zweiten Teilbereich des Wellenleiters umgebenden Resonators.

Vorzugsweise beträgt die Ausdehnung des zweiten Teilbereichs des Resonators zwischen 60% und 90% der Länge des Wellenleiters in Bezug auf die Längsachse des Wellenleiters.

Die Erfindung soll nachfolgend anhand eines in den Figuren dargestellten Ausführungsbeispiels näher erläutert werden. Es zeigen:
- Fig. 1:: Eine erfindungsgemäße Vorrichtung zur Erzeugung von Laserstrahlung in schematischer, geschnit- tener Darstellung;
- Fig. 2:: weitere erfindungsgemäße Resonatorkonfigurationen (intra/extra-cavity+Verstärker); und
- Fig. 3:: das Transmissionsverhalten eines herkömmlichen n- Substrats im Vergleich zu einem Si-Subtrat für THz-Strahlung.

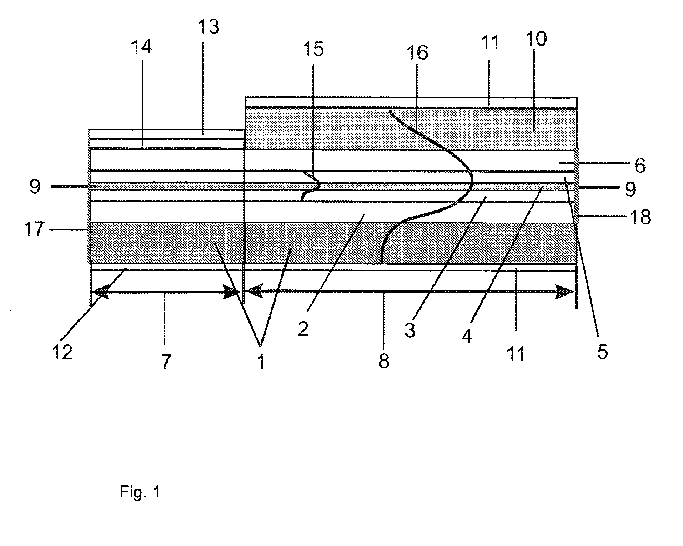

Fig. 1 zeigt eine erfindungsgemäße Vorrichtung zur Erzeugung von THz-Strahlung in schematischer, geschnittener Darstellung.

Die Vorrichtung weist ein Substrat 1 auf, welches im ersten axialen Abschnitt 7 aus einem semiisolierenden Material, beispielsweise Galliumarsenid, Indiumphosphid oder Galliumnitrid, mit einer geringen Dämpfung für elektromagnetische Strahlung im Bereich von 0.1 THz bis 10 THz und im zweiten axialen Abschnitt 8 ebenfalls aus einem (nicht notwendigerweise leitenden) Material mit einer geringen Dämpfung für elektromagnetische Strahlung im Bereich von 0.1 THz bis 10 THz besteht.
In den bekannten Halbleiterstrukturen nach dem Stand der Technik, in denen THz- Strahlung erzeugt wird, tritt starke Absorption im Substrat auf und der räumliche Bereich der Verstärkung der optischen Welle und das Maximum der THz Welle stimmen nicht überein (geringer Gewinn für die THz Welle).

Weiterhin weist die erfindungsgemäße Vorrichtung die Wellenleiterschichten 3, 5, die Mantelschichten 2, 6 sowie die aktive Schicht 4 auf, wobei im ersten axialen Abschnitt 7 mittels der Kontakte 12, 13 Ladungsträger injizierbar sind und damit der erste Bereich, je nach Konfiguration unter Einbeziehung der Rückfacette 18, der Frontfacette 17 und / oder eines externen Resonators eine Laserdiode ausbildet. Mindestens zwei separate longitudinale Lasermoden werden im ersten axialen Abschnitt 7 (beispielsweise durch Gitter) angeregt und verstärkt, wobei Terahertz-Strahlung durch Differenzfrequenzerzeugung der mindestens zwei longitudinalen Moden generiert werden kann. Die Anregung der mindestens zwei separaten longitudinalen Lasermoden kann alternativ auch durch externe Resonatoren erfolgen.

So kann beispielsweise zur Erzeugung einer Strahlung von 1 THz eine optische Welle 15 bei 840 nm (darauf muss die aktive Schicht 4 ausgelegt sein) angeregt werden. Um eine Welle 16 mit 1,0 THz mittels Differenzfrequenzerzeugung zu erzeugen, muss der Abstand der longitudinalen Lasermoden 2.355 nm betragen. Im Ausführungsbeispiel handelt es sich hier um einen Laser mit internen Gittern, die 2 Moden erzeugen. Werden zur Anregung der longitudinalen Lasermoden frequenzselektive Gitter 2.Ordnung verwendet, betragen die Gitterperioden 254 nm und 256 nm. Diese Werte können je nach Zielstellung (THz-Welle 16 zwischen 0.1 und 10 THz) und verwendeter aktiver Schicht 4 und verwendeter Anregung der longitudinalen Lasermoden (intra-cavity oder extra-cavity) entsprechend umgerechnet werden. Dabei kann aus der Anregung der aktiven Schicht 4 (optische Welle 15) bei vorgegebener Frequenz für die THz-Welle der Abstand der longitudinalen Lasermoden berechnet werden. Aus dem Abstand der longitudinalen Lasermoden lassen sich dann die entsprechenden intra-cavity/ extra-cavity-Parameter berechnen.

In der erfindungsgemäßen Struktur ist der Wellenleiter so gestaltet, dass neben der optischen Welle 15 auch eine THz-Welle 16 geführt und verstärkt wird. Das Gewinnmedium 4 ist dabei in der günstigsten Ausführungsform so beschaffen, dass es elektronische Übergänge beinhaltet, die in Resonanz mit der THz-Welle 16 sind und diese parametrisch verstärken. Die verlustarme Wellenführung der THz-Welle wird durch das Substrat 1 sowie die Schicht 10, welche eine geringe Dämpfung für elektromagnetische Strahlung im Bereich von 0.1 THz bis 10 THz aufweisen, realisiert. Die reflektiven Schichten 11 verhindern ein Auskoppeln der THz-Welle 16 über den Wellenleiter 1, 10. Der Wellenleiter gewährleistet zudem die Phasenanpassung zwischen der optischen Welle 15 und der THz-Welle 16.

Im ersten axialen Abschnitt 7 stimmt das Maximum der THz Welle 16 nicht mit dem Gewinn-Medium überein. Deshalb ist der zweite axiale Abschnitt 8 so gestaltet, dass eine Resonatorstruktur realisiert wird, in der das Maximum der THz Welle 16 mit dem Gain-Medium 4 übereinstimmt und der Resonator für die THz- Welle angepasst ist. Dabei ist zu berücksichtigen, dass der optische Wellenleiter 3, 5 bevorzugt (bzw. möglichst) zentral im THz-Wellenleiter 1, 10 positioniert ist, um einen hohen THz-Confinement-Faktor bzw. eine gute Kopplung zwischen optischer und THz-Mode zu realisieren.

Zur Herstellung der Struktur werden zunächst alle funktionellen Schichten (1-6 und 12-14) über die Länge des ersten Abschnitts 7 und des zweiten Abschnitts 8 kontinuierlich ausgebildet, und nachfolgend werden das Substrat 1 und die Kontaktschichten 12, 13 und 14 im zweiten axialen Abschnitt 8 weggeätzt und durch THz Wellenführungsschichten (zweites Substratmaterial 1 und Schicht 10) ersetzt. Die THz Resonatoren 11 werden dann auf die THz Wellenführungsschichten 1, 10 aufgebracht. Vorteil dieser Struktur ist, dass das Maximum der THz Welle 16 mit dem Gain-Medium 4 übereinstimmt.

Die Struktur weist weiterhin eine Frontfacette 17 mit einer geringen Reflektivität für die THz-Welle 16 und eine Rückfacette 18 mit einer hohen Reflektivität für die THz-Welle 16 auf. Hierdurch wird die THz-Welle 16 über die Frontfacette 17 ausgekoppelt.

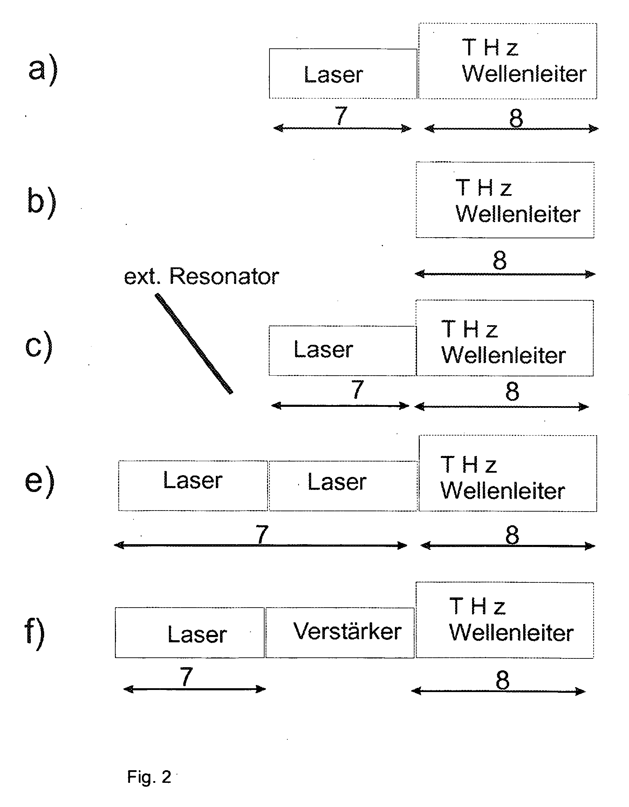

Fig. 2 zeigt bevorzugte Resonatorkonfigurationen zur Erzeugung kohärenter Terahertz-Strahlung nach der vorliegenden Erfindung. Fig. 2 a) zeigt dabei die Standardkonfiguration (korrespondiert mit Fig. 1), in der die zwei Moden der optischen Welle 15 (also zwei Wellen mit definiertem Wellenlängenabstand zwischen von 0,00001 nm bis 100 nm) im ersten Abschnitt 7 (der als Laser fungiert) erzeugt werden. Die THz-Welle 16 wird dabei durch Differenzfrequenzerzeugung der zwei Moden im ersten Abschnitt 7 erzeugt und im zweiten Abschnitt 8 (der als THz Wellenleiter mit geringer Dämpfung fungiert) verstärkt.

Fig. 2 b) zeigt einen erfindungsgemäßen THz-Wellenleiter (weist alle Merkmale des zweiten Abschnitts 8 der erfindungsgemäßen Vorrichtung auf - es fehlt also der erste axiale Bereich 7), der mit einer Laserdiode (erster Abschnitt 7) zur Erzeugung kohärenter Terahertz-Strahlung gekoppelt werden kann. Der erfindungsgemäße THz-Wellenleiter weist sowohl einen inneren Wellenleiter für eine optische Welle (300 nm -1500 nm) als auch einen äußeren Wellenleiter für eine THz-Welle auf.

Eine Modenselektion kann durch externe (Fig. 2 c) oder interne frequenzselektive Elemente erfolgen. Anstatt zweier frequenzselektiver Elemente kann auch ein einzelnes frequenzselektives Element verwendet werden, das beide Moden anregt, beispielsweise ein Gitter mit zwei unterschiedlichen, überlagerten Gitterkonstanten.

Fig. 2 d) zeigt eine alternative, erfindungsgemäße Vorrichtung zur Erzeugung kohärenter Terahertz-Strahlung, bei der die zwei optischen Wellen mit definiertem Wellenlängenabstand zwischen 0,00001 nm bis 100 nm nicht durch frequenzselektive(s) Element(e), sondern durch zwei hintereinander geschaltete Laser realisiert wird, die Laserstrahlung mit einem definierten Wellenlängenabstand zwischen 0,00001 nm bis 100 nm generieren.

Fig. 2 e) zeigt eine erfindungsgemäße Vorrichtung zur Erzeugung kohärenter Terahertz-Strahlung, bei der zwischen dem ersten Bereich und dem zweiten Bereich ein Verstärker angeordnet ist.

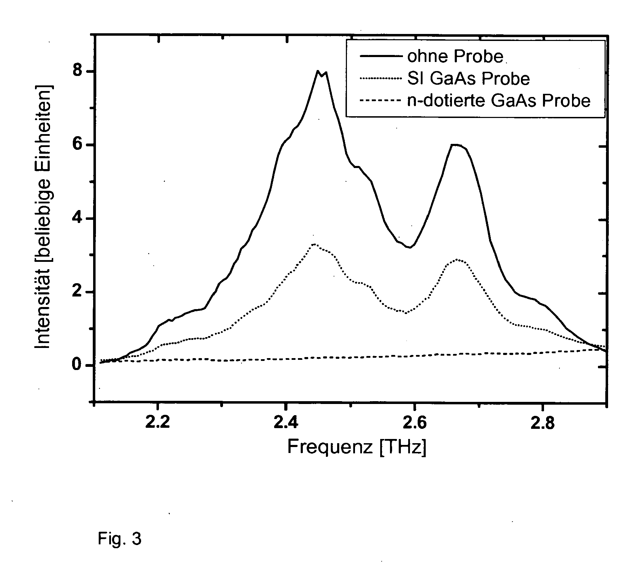

In Fig. 3 ist das Transmissionsverhalten von THz-Strahlung in einem n-dotierten GaAs-Substrat (wie es in Vorrichtungen nach dem Stand der Technik verwendet wird) und in einem semiisolierenden GaAs -Substrat dargestellt. Es zeigt sich, dass die Absorption im n- dotierten GaAs-Substrat viel stärker ist, weshalb die erfindungsgemäße Anordnung eines semiisolierenden GaAs -Substrats im ersten axialen Abschnitt 7 zu einer höheren Effizienz führt.

### Bezugszeichenliste

- 1: Substrat/ erstes und zweites Substratmaterial
- 2: erste Mantelschicht
- 3: erste Wellenleiterschicht
- 4: Schicht eines aktiven Mediums
- 5: zweite Wellenleiterschicht
- 6: zweite Mantelschicht
- 7: ersten Bereich des Substrats
- 8: zweiter Bereich des Substrats
- 9: Längsachse des Wellenleiters
- 10: Schicht aus einem dritten Material/ zusätzliche Resonatorschicht
- 11: reflektierende Schicht
- 12: erster Kontakt
- 13: zweiter Kontakt
- 14: Kontaktschicht
- 15: optische Welle
- 16: Terahertz-Welle
- 17: Frontfacette
- 18: Rückfacette

## Patentansprüche

1. Vorrichtung zur Erzeugung von elektromagnetischer Strahlung (16) im Bereich von 0.1 THz bis 10 THz durch Differenzfrequenzerzeugung von zwei longitudinalen Lasermoden aufweisend:
ein Substrat (1), eine auf dem Substrat (1) angeordnete, erste Mantelschicht (2), eine auf der ersten Mantelschicht (2) angeordnete, erste Wellenleiterschicht (3), eine auf der ersten Wellenleiterschicht (3) angeordnete Schicht (4) eines aktiven Mediums, eine auf der Schicht (4) des aktiven Mediums angeordnete, zweite Wellenleiterschicht (5), eine auf der zweiten Wellenleiterschicht (5) angeordnete, zweite Mantelschicht (6), sowie einen ersten Kontakt (12) und einen zweiten Kontakt (13) zur Injektion von Ladungsträgern,
**dadurch gekennzeichnet, dass**
die aktive Schicht (4) zwischen einer Frontfacette (17) und einer Rückfacette (18) angeordnet ist und die Frontfacette (17) und die Rückfacette (18) direkt kontaktiert, wobei sich der erste Kontakt (12) und der zweite Kontakt (13) über einen ersten Teilbereich (7) entlang der Längsachse (9) der Wellenleiterschichten (3, 5) zwischen Frontfacette (17) und Rückfacette (18) erstrecken, und
wobei das Substrat (1) im ersten Teilbereich (7) aus einem ersten, semiisolierenden Substratmaterial mit einer Dämpfung geringer als 90% für elektromagnetische Strahlung im Bereich von 0.1 THz bis 10 THz und in einem zweiten, zum ersten Teilbereich (7) komplementären Teilbereich (8) aus einem zweiten Substratmaterial mit einer Dämpfung geringer als 90% entlang der Längsachse (9) der Wellenleiterschichten (3, 5) für elektromagnetische Strahlung im Bereich von 0.1 THz bis 10 THz besteht, wobei sich der erste Teilbereich (7) und der zweite Teilbereich (8) in Summe über den gesamten Bereich zwischen Frontfacette (17) und Rückfacette (18) erstrecken, und wobei auf der zweiten Mantelschicht (6) lediglich im zweiten Teilbereich (8) des Substrats (1) eine Zusatzschicht (10) aus einem dritten Material mit einer Dämpfung geringer als 90% für elektromagnetische Strahlung im Bereich von 0.1 THz bis 10 THz angeordnet ist, und sowohl die der zweiten Mantelschicht (6) abgewandte Seite der Zusatzschicht (10) als auch die der ersten Mantelschicht (2) abgewandte Seite des Substrats (1) eine für elektromagnetische Strahlung im Bereich von 0.1 THz bis 10 THz reflektierende Schicht (11) aufweist.

2. Vorrichtung nach Anspruch 1,
**dadurch gekennzeichnet, dass**
die Schichtdicke des Substrats (1) im ersten Teilbereich (7) identisch mit der Schichtdicke des Substrats (1) im zweiten Teilbereich (8) ist.

3. Vorrichtung nach einem der vorhergehenden Ansprüche,
**dadurch gekennzeichnet, dass**
die Schichtdicke des Substrats (1) im zweiten Teilbereich (8) identisch mit der Dicke der Zusatzschicht (10) ist.

4. Vorrichtung nach einem der vorhergehenden Ansprüche,
**dadurch gekennzeichnet, dass**
die Schichtdicke des Substrats (1) im ersten Teilbereich (7), die Schichtdicke des Substrats (1) im zweiten Teilbereich (8) und die Dicke der Zusatzschicht (10) zwischen 80 µm und 160 µm beträgt.

5. Vorrichtung nach einem der vorhergehenden Ansprüche,
**dadurch gekennzeichnet, dass**
die Frontfacette (17) eine Reflektivität kleiner als 5 % und/oder die Rückfacette (18) eine Reflektivität größer als 85 % für elektromagnetische Strahlung im Bereich von 0.1 THz bis 10 THz aufweisen.

6. Vorrichtung nach einem der vorhergehenden Ansprüche,
**dadurch gekennzeichnet, dass**
der Wellenleiter (2, 3, 5, 6) im zweiten Teilbereich (8) so gestaltet ist, dass elektromagnetische Strahlung im Bereich von 0.1 THz bis 10 THz (16) und optische Strahlung (15) dieselbe Ausbreitungsgeschwindigkeit entlang der Längsachse (9) der Wellenleiterschichten (3, 5) aufweisen.

7. Vorrichtung nach einem der vorhergehenden Ansprüche,
**dadurch gekennzeichnet, dass**
die Vorrichtung zwei frequenzselektive Elemente aufweist, die zur Anregung von zwei unterschiedlichen Moden mit einem Wellenlängenabstand von 0,00001 nm bis 100 nm geeignet sind.

## Claims

1. Device for the generation of electromagnetic radiation (16) in the range of 0.1 THz to 10 THz by difference frequency generation of two longitudinal laser modes, comprising:
a substrate (1), a first jacket layer (2) disposed on the substrate (1), a first waveguide layer (3) disposed on the first jacket layer (2), a layer (4) of an active medium disposed on the first waveguide layer (3), a second waveguide layer (5) disposed on the layer (4) of the active medium, a second jacket layer (6) disposed on the second waveguide layer (5), and a first contact (12) and a second contact (13) for the injection of charge carriers,
**characterised in that**
the active layer (4) is disposed between a front facet (17) and a rear facet (18) and directly contacts the front facet (17) and the rear facet (18), wherein the first contact (12) and the second contact (13) extend over a first partial region (7) along the longitudinal axis (9) of the waveguide layers (3, 5) between the front facet (17) and the rear facet (18), and wherein, in the first partial region (7), the substrate (1) is made of a first semi-insulating substrate material having an attenuation lower than 90% for electromagnetic radiation in the range of 0.1 THz to 10 THz and in a second partial region (8) complementary to the first partial region (7) is made of a second substrate material having an attenuation lower than 90% along the longitudinal axis (9) of the waveguide layers (3, 5) for electromagnetic radiation in the range of 0.1 THz to 10 THz, wherein the first partial region (7) and the second partial region (8) extend over the entire region between the front facet (17) and the rear facet (18), in total, and wherein a supplementary layer (10) made of a third material having an attenuation lower than 90% for electromagnetic radiation in the range of 0.1 THz to 10 THz is disposed on the second jacket layer (6) only in the second partial region (8) of the substrate (1), and the side of the supplementary layer (10) facing away from the second jacket layer (6) as well as the side of the substrate (1) facing away from the first jacket layer (2) comprise a layer (11) reflective for electromagnetic radiation in the range of 0.1 THz to 10 THz.

2. Device according to claim 1,
**characterised in that**
the layer thickness of the substrate (1) in the first partial region (7) is identical to the layer thickness of the substrate (1) in the second partial region (8).

3. Device according to one of the preceding claims,
**characterised in that**
the layer thickness of the substrate (1) in the second partial region (8) is identical to the thickness of the supplementary layer (10).

4. Device according to one of the preceding claims,
**characterised in that**
the layer thickness of the substrate (1) in the first partial region (7), the layer thickness of the substrate (1) in the second partial region (8) and the thickness of the supplementary layer (10) is between 80 µm and 160 µm.

5. Device according to one of the preceding claims,
**characterised in that**
the front facet (17) has a reflectivity less than 5% and/or the rear facet (18) has a reflectivity greater than 85% for electromagnetic radiation in the range of 0.1 THz to 10 THz.

6. Device according to one of the preceding claims,
**characterised in that**
the waveguide (2, 3, 5, 6) in the second partial region (8) is designed such that electromagnetic radiation (16) in the range of 0.1 THz to 10 THz and optic radiation (15) have the same propagation speed along the longitudinal axis (9) of the waveguide layers (3, 5).

7. Device according to one of the preceding claims,
**characterised in that**
the device comprises two frequency-selective elements appropriate for the excitation of two different modes having a wavelength distance of 0.00001 nm to 100 nm.

## Revendications

1. Dispositif pour la production de rayonnement (16) électromagnétique dans la plage de 0,1 THz à 10 THz par la génération de fréquence de différence de deux modes laser longitudinaux, comprenant :
un substrat (1), une première couche (2) de gaine disposée sur le substrat (1), une première couche (3) de guide d'ondes disposée sur la première couche (2) de gaine, une couche (4) d'un milieu actif disposée sur la première couche (3) de guide d'ondes, une deuxième couche (5) de guide d'ondes disposée sur la couche (4) du milieu actif, une seconde couche (6) de gaine disposée sur la deuxième couche (5) de guide d'ondes, et un premier contact (12) et un deuxième contact (13) destinés à l'injection de porteurs de charges,
**caractérisé en ce que**
la couche (4) active est disposée entre une facette (17) avant et une facette (18) arrière et entre en contact direct avec la facette (17) avant et la facette (18) arrière, le premier contact (12) et le deuxième contact (13) s'étendant sur une première zone (7) partielle le long de l'axe (9) longitudinal des couches (3, 5) de guides d'ondes, entre la facette (17) avant et la facette (18) arrière, et le substrat (1) consistant, dans la première zone (7) partielle, en un premier matériau de substrat semi-isolant ayant une atténuation inférieure à 90% pour le rayonnement électromagnétique dans la plage de 0,1 THz à 10 THz, et le substrat (1) consistant, dans une seconde zone (8) partielle complémentaire à la première zone (7) partielle, en un deuxième matériau de substrat ayant une atténuation inférieure à 90% le long de l'axe (9) longitudinal des couches (3, 5) de guides d'ondes pour le rayonnement électromagnétique dans la plage de 0,1 THz à 10 THz, la première zone (7) partielle et la seconde zone (8) partielle s'étendant sur la zone entière entre la facette (17) avant et la facette (18) arrière, au total, et une couche (10) supplémentaire en un troisième matériau ayant une atténuation inférieure à 90% pour le rayonnement électromagnétique dans la plage de 0,1 THz à 10 THz étant disposée, sur la deuxième couche (6) de gaine, seulement dans la seconde zone (8) partielle du substrat (1), et le côté de la couche (10) supplémentaire détourné de la deuxième couche (6) de gaine ainsi que le côté du substrat (1) détourné de la première couche (2) de gaine comprenant une couche (11) réfléchissante pour le rayonnement électromagnétique dans la plage de 0,1 THz à 10 THz.

2. Dispositif selon la revendication 1,
**caractérisé en ce que**
l'épaisseur de couche du substrat (1) dans la première zone (7) partielle est identique à l'épaisseur de couche du substrat (1) dans la seconde zone (8) partielle.

3. Dispositif selon l'une des revendications précédentes,
**caractérisé en ce que**
l'épaisseur de couche du substrat (1) dans la seconde zone (8) partielle est identique à l'épaisseur de couche (10) supplémentaire.

4. Dispositif selon l'une des revendications précédentes,
**caractérisé en ce que**
l'épaisseur de couche du substrat (1) dans la première zone (7) partielle, l'épaisseur de couche du substrat (1) dans la seconde couche partielle (8), et l'épaisseur de la couche (10) supplémentaire sont dans la plage comprise entre 80 µm et 160 µm.

5. Dispositif selon l'une des revendications précédentes,
**caractérisé en ce que**
la facette (17) avant a une réflectivité inférieure à 5%, et/ou la facette (18) arrière a une réflectivité supérieure à 85% pour le rayonnement électromagnétique dans la plage de 0,1 THz à 10 THz.

6. Dispositif selon l'une des revendications précédentes,
**caractérisé en ce que**
le guide (2, 3, 5, 6) d'ondes dans la seconde zone (8) partielle est conçue de sorte que le rayonnement (16) électromagnétique dans la plage de 0,1 THz à 10 THz et le rayonnement (15) optique ont la même vitesse de propagation le long de l'axe (9) longitudinal des couches (3, 5) de guides d'ondes.

7. Dispositif selon l'une des revendications précédentes,
**caractérisé en ce que**
le dispositif comprend deux éléments sélectifs en fréquence aptes à l'excitation de deux modes différents ayant une distance de longueur d'onde de 0,00001 nm à 100 nm.
